# EUROPEAN PATENT APPLICATION

(11) **EP 1 471 575 A1**
(43) Date of publication of application: **27.10.2004**
(21) Application number: 03252593.3
(22) Date of filing: 24.04.2003
(51) Int. Cl.: H01L 23/66, H01L 23/498

(54) **Rf chip carrier having inductors provided therein and method of manufacturing the same**

(71) Applicant: SAMSUNG ELECTRONICS CO., LTD., Suwon-City, Kyungki-do (KR)
(72) Inventor: Woo, San-hyun, Gangnam-gu, Seoul (KR); Lee, Kwang-du, Nowon-gu, Seoul (KR)
(74) Representative: Greene, Simon Kenneth

(57) **Abstract**

Provided are high frequency inductors having low inductance and low inductance variation, to be used in an RF unit for a wireless communication terminal, and a method of manufacturing the high frequency inductors. The high frequency inductors include first inductor means (46) and second inductor means (48a). The first inductor means (46) are vias through a low loss dielectric layer that electrically connect an RF chip (50) placed over a substrate (40) at a predetermined distance to the substrate (40) and are enclosed by a low loss dielectric material (42). The second inductor means (48a) are solder bumps that connect the RF chip (50) to the first inductor means (46).

## Description

The present invention relates to an inductor used in a radio frequency (RF) unit for a wireless communication terminal, and more particularly, to an inductor having a low inductance value and a low inductance variation.

Wireless communication terminals in the current marketplace are compact, light, consume a small amount of power, and unit cost thereof is low. Nevertheless, a further reduction in the size, power consumption, and fabrication costs are the first consideration in manufacturing high-quality wireless communication terminals.

For this purpose, a RF port of a wireless communication terminal has to be made into one chip. Due to this, it is very important to reduce the size of electronic devices constituting the RF port, in particular, the size of an inductor contained in a chip. In addition, maintaining the stability as well as a high Q-factor of an inductor is also important.

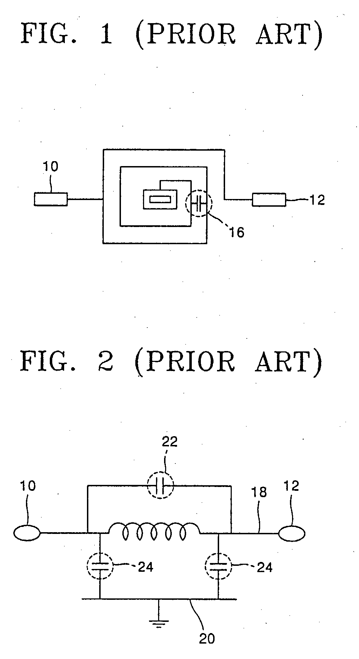

The inductor used in the RF port is mainly a spiral inductor or a bondwire inductor. As shown in FIG. 1, a conventional spiral inductor is formed by winding a metal wire several times on a plane.

FIG. 2 is an equivalent circuit diagram of the conventional spiral inductor shown in FIG. 1. Referring to FIG. 2, a metal wire 18 is formed between an input port 10 and an output port 12 of the conventional inductor. A first parasitic capacitor 22 is positioned on the metal wire 18. Second parasitic capacitors 24 are interposed between the metal wire 18 and a substrate 20.

A self-resonant frequency (SRF) and a Q-factor of the conventional inductor become lower due to the first and second parasitic capacitors 22 and 24. In particular, if the substrate 20 is a silicon substrate, a signal input via the input port 10 leaks to the substrate 20, which increases the substrate loss.

The bondwire inductor is formed of a wire used in packaging bare chips (not shown) on the substrate, and has a great Q-factor and low inductance. However, since the bondwire inductor occupies a large area when packaging the bare chips, the entire area of an RF chip increases. Also, since the shape and length of the wire may gradually vary when processes of forming the bondwire inductor are performed, the inductance of the bondwire inductor may gradually vary, too.

In a case where an inductor having a low inductance is used, the effect of inductance variation may be large although the inductance variation is small. A low noise amplifier (LNA) of the wireless communication terminal corresponds to this case. In other words, the input impedance of the LNA in the wireless communication terminal depends on a source inductor of a first transistor and has to be reduced with an increase in a frequency. For example, a source inductor used in a LNA having a wireless LAN USII band of 5.725 - 5.825GHz is mainly a bondwire inductor, a value of which is about 0.5nH. In this case, the inductance of the source inductor may have an error of about 0.1 nH, which may be caused by a process variation. However, the error degrades input reflection to 10dB or more. This is a big problem in designing LNA.

According to an aspect of the present invention, there are provided inductors used in a RF unit for a wireless communication terminal. The inductors include first inductor means and second inductor means. The first inductor means electrically connect an RF chip placed over a substrate at a predetermined distance to the substrate and are enclosed by a low loss dielectric material. The second inductor means connect the RF chip to the first inductor means.

Hence, the present invention provides an inductor in an RF unit for a wireless terminal, which can prevent a reduction in a Q-factor due to a substrate loss and a reduction in an SRF due to parasitic capacitors so as to lower an inductance and minimize a variation in the inductance and can reduce the area of the RF chip.

The first inductor means are conductive plugs, and the second inductor means are flip-chip bumps contacting the upper portions of the conductive plugs.

The conductive plugs are connected to the substrate via third inductor means.

The inductors further include a conductive adhesive film between the third inductor means and the substrate and/or between the flip-chip bumps and the conductive plugs.

According to another aspect of the present invention, there is also provided a method of manufacturing inductors. An interlayer dielectric layer having a low dielectric constant is formed on a substrate. First inductor means, which penetrate through the interlayer dielectric layer so as to be connected to the substrate, are formed. An RF chip is formed over the interlayer dielectric film at a predetermined distance via the first inductor means and second inductor means connected to pad areas of the RF chip.

When forming the first inductor means, contact holes are formed in the interlayer dielectric layer to expose the substrate, and then the contact holes are filled with conductive plugs that are the first inductor means.

When forming the RF chip, flip-chip bumps are formed beneath the pad areas of the RF chip, the RF chip is arranged so that the flip-chip bumps correspond on a one-to-one basis to the conductive plugs, and the substrate and the RF chip are pressed at a predetermined temperature and with a pressure so as to bond the RF chip to the substrate.

According to still another aspect of the present invention, when forming the RF chip, bumps contacting the conductive plugs are formed on the interlayer dielectric layer, the RF chip is arranged so that the pad areas of the RF chip correspond on a one-to-one basis to the bumps, and the substrate and the RF chip are pressed at a predetermined temperature and with a predetermined pressure so as to bond the RF chip to the substrate.

According to yet another aspect of the present invention, there is also provided a method of manufacturing inductors. An interlayer dielectric layer, which has a low dielectric constant and includes first inductor means formed in the interlayer dielectric layer, is formed. The interlayer dielectric layer is placed over a substrate at a predetermined distance via second inductor means connecting the first inductor means to the substrate. An RF chip is placed over the interlayer dielectric layer at a predetermined distance via third inductor means connecting the first inductor means to pad areas of the RF chip.

When forming the interlayer dielectric layer, the interlayer dielectric layer is formed on a first substrate, contact holes are formed in the interlayer dielectric layer so as to expose the first substrate, the contact holes are filled with conductive plugs that are the first inductor means, and the interlayer dielectric layer is separated from the first substrate.

The second and third inductor means are flip-chip bumps.

When placing the interlayer dielectric layer over the substrate, the flip-chip bumps are formed on the substrate in consideration of a distance between the pad areas of the RF chip and the area of the pad areas, the interlayer dielectric layer is arranged so that the conductive plugs correspond on a one-to-one basis to the flip-chip bumps, and the substrate and the interlayer dielectric layer are pressed at a predetermined temperature and with a predetermined pressure to flip-chip bond the interlayer dielectric layer to the substrate.

According to yet another aspect of the present invention, when placing the interlayer dielectric layer over the substrate, flip-chip bumps contacting the conductive plugs are formed on a side of the interlayer dielectric layer, and the substrate and the interlayer dielectric layer are pressed at a predetermined temperature and with a predetermined pressure to bond the interlayer dielectric layer to the substrate.

When placing the RF chip over the interlayer dielectric layer, the flip-chip bumps are formed beneath the pad areas of the RF chip, the RF chip is arranged so that the flip-chip bumps correspond on a one-to-one basis to the conductive plugs, and the substrate and the interlayer dielectric layer are pressed at a predetermined temperature and with a predetermined pressure to bond the interlayer dielectric layer to the substrate.

Before the interlayer dielectric layer is flip-chip bonded to the substrate or before the interlayer dielectric layer is flip-chip bonded to the RF chip, a conductive adhesive film is formed on the substrate or on the interlayer dielectric layer.

The above features and advantages of the present invention will become more apparent by describing in detail exemplary embodiments thereof with reference to the attached drawings in which:
FIG. 1 is a plan view of a spiral inductor according to the prior art;
FIG. 2 is a cross-sectional equivalent circuit diagram of the inductor shown in FIG. 1;
FIG. 3 is a cross-sectional view of inductors used in an RF unit for a wireless communication terminal according to a first embodiment of the present invention;
FIG. 4 illustrates portion **A** of the structure shown in FIG. 3 and an equivalent circuit thereof;
FIGS. 5 through 8 are cross-sectional views each illustrating inductors used in an RF unit for a wireless communication terminal according to embodiments of the present invention;
FIGS. 9 through 13 are cross-sectional views for explaining steps of a method of manufacturing the inductors according to an embodiment of the present invention;
FIGS. 14 through 17 are cross-sectional views for explaining steps of a method of manufacturing the inductors according to another embodiment of the present invention; and
FIGS. 18 through 22 are cross-sectional views for explaining steps of a method of manufacturing the inductors according to still another embodiment of the present invention.

Hereinafter, inductors used in an RF unit for a wireless communication terminal and a manufacturing method thereof according to embodiments of the present invention will be described in detail with reference to the attached drawings. In the drawings, the thicknesses of layers or regions are exaggerated for clarity.

First, the inductors used in the RF unit for the wireless communication terminal will be described below.

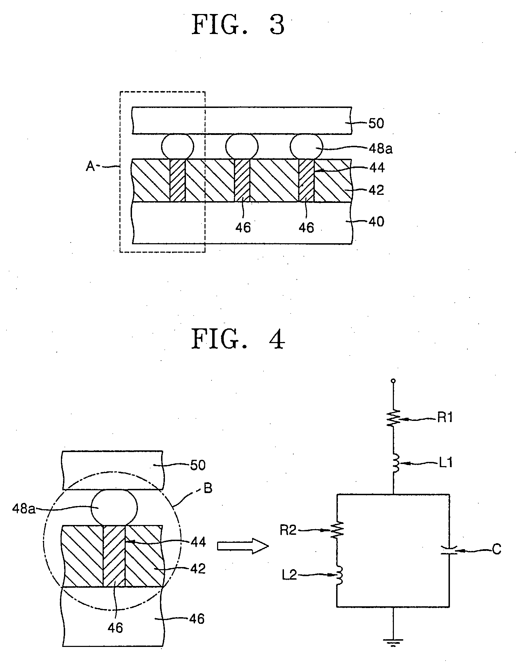

Referring to FIG. 3, an interlayer dielectric layer 42 having a predetermined thickness is formed on a substrate 40. The substrate 40 is a printed circuit board (PCB), a ceramic substrate, a glass substrate, a silicon substrate, or the like. Alternatively, the substrate 40 may be a substrate on which chips can be packaged. It is preferable that the interlayer dielectric layer 42 has a low dielectric constant, conductivity, and loss tangent. Contact holes 44, which expose the substrate 40, are formed in the interlayer dielectric layer 42. The contact holes 44 are filled with conductive plugs 46. The conductive plugs 46 are used as first inductor means. Flip-chip bumps 48a, which cover the entire exposed upper surfaces of the conductive plugs 44, are formed on the interlayer dielectric layer 42. The flip-chip bumps 48a are used as second inductor means. An RF chip 50 having active and passive devices is placed at a predetermined distance from the surface of the interlayer dielectric layer 42. The RF chip 50 is supported by the flip-chip bumps 48a contacting pads (not shown) thereof. The flip-chip bumps 48a serve to connect the conductive plugs 46 to the pads of the RF chip 50 while being positioned between the interlayer dielectric layer 42 and the RF chip 50.

The conductive plugs 46 and the flip-chip bumps 48a contain inductive, resistive, and capacitive components. This will be clearly described with reference to FIG. 4 illustrating the conductive plugs 46 and the flip-chip bumps 48a with an equivalent circuit.

In the equivalent circuit shown in FIG. 4, a first resistance R1 and a first inductor L1 are realized by the flip-chip bumps 48a, and a second resistance R2 and a second inductor L2, which are connected to a capacitor C in parallel, are realized by the conductive plugs 46 filling the contact holes 44. The capacitor C is composed of the conductive plugs 46, the substrate 40, and the interlayer dielectric layer 42.

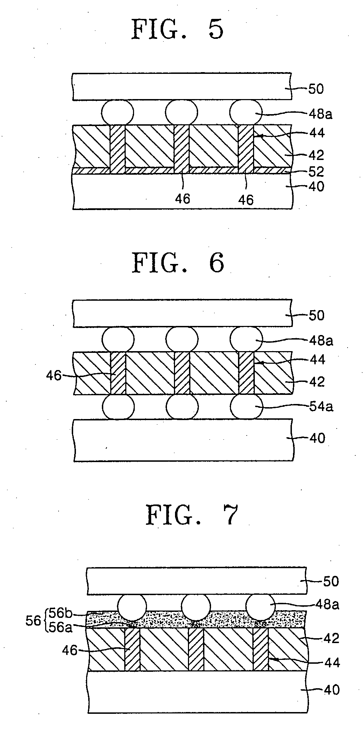

FIG. 5 is a cross-sectional view illustrating inductors used in an RF unit for a wireless communication terminal according to another embodiment of the present invention. Referring to FIG. 5, a conductive adhesive film 52 and an interlayer dielectric layer 42 are sequentially formed on a substrate 40. The conductive adhesive film 52 is formed to strongly adhere the interlayer dielectric layer 42 onto the substrate 40. Contact holes 44, which expose predetermined areas of the substrate 40, are formed in the conductive adhesive film 52 and the interlayer dielectric layer 42. The contact holes 44 are filled with conductive plugs 46. The entire exposed upper surfaces of the conductive plugs 46 contact flip-chip bumps 48a on the interlayer dielectric layer 42. Upper surfaces of the flip-chip bumps 48a contact pad areas (not shown) of an RF chip 50. Due to the flip-chip bumps 48a, the interlayer dielectric layer 42 is separated from the RF chip 50 by a distance corresponding to the height of the flip-chip bumps 48a.

FIG. 6 is a cross-sectional view illustrating inductors used in an RF unit for a wireless communication terminal according to still another embodiment of the present invention.

The present embodiment is characterized in that flip-chip bumps are formed on and beneath an interlayer dielectric layer 42. In detail, referring to FIG. 6, first flip-chip bumps 54a which are used as third inductor means are formed on a substrate 40. The first flip-chip bumps 54a serve as supports so that the interlayer dielectric 42 is formed over the substrate 40. Contact holes 44, which expose the first flip-chip bumps 54a, are formed in the interlayer dielectric layer 42. The contact holes 44 are filled with conductive plugs 46. Second flip-chip bumps 48a, which contact the conductive plugs 46, are formed on the interlayer dielectric layer 42. The second flip-chip bumps 48a serve as supports so that an RF chip 50 is placed over the interlayer dielectric layer 42.

In the present embodiment, the first flip-chip bumps 54a are used as inductor means.

FIG. 7 is a cross-sectional view illustrating inductors used in an RF unit for a wireless communication terminal according to yet another embodiment of the present invention. Referring to FIG. 7, a conductive adhesive film 56, which covers the entire exposed surfaces of conductive plugs 46 and the entire surface of an interlayer dielectric layer 42, is formed between the interlayer dielectric layer 42 and flip-chip bumps 48a. Here, it is preferable that the conductive adhesive film 56 is an anisotropic conductive adhesive film, an isotropic conductive adhesive film, or a non-conductive adhesive film, an electric resistance of which is reduced in a direction toward which pressure is applied. In other words, since portions 56a of the conductive adhesive film 56 pressed by the flip-chip bumps 48a have a lower electric resistance than the remaining portions 56b of the conductive adhesive film 56, an electric signal is transmitted from the flip-chip bumps 48a only to the conductive plugs 46.

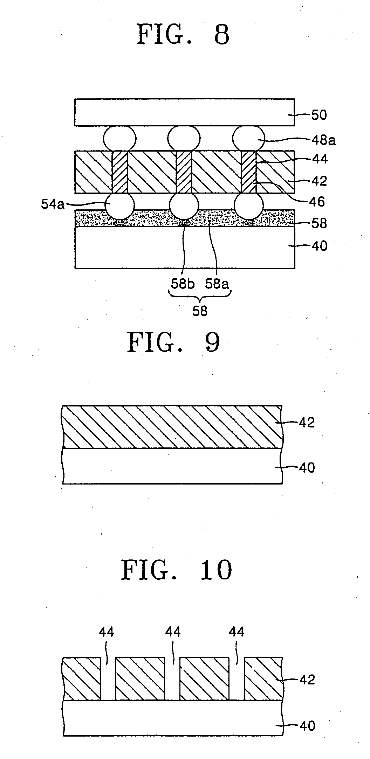

FIG. 8 is a cross-sectional view illustrating inductors used in an RF unit for a wireless communication terminal according to still yet another embodiment of the present invention.

As shown in FIG. 8, the present embodiment is different from the embodiment described with reference to FIG. 6 in that a conductive adhesive film 58 is formed between a substrate 40 and first flip-chip bumps 54a. It is preferable that the conductive adhesive film 58 is the same as the conductive adhesive film 56 described in the embodiment with reference to FIG. 7.

A method of manufacturing inductors used in an RF unit for a wireless communication terminal will now be described according to other embodiments of the present invention.

FIGS. 9 through 13 are cross-sectional views for explaining steps of a method of manufacturing inductors used in an RF unit for a wireless communication terminal, according to an embodiment of the present invention.

As shown in FIG. 9, an interlayer dielectric layer 42 is formed on a substrate 40. The substrate 40 may be a PCB, a ceramic substrate, a glass substrate, a silicon substrate, or the like. The substrate 40 may also be a substrate on which chips can be packaged. It is preferable that the interlayer dielectric layer 42 is formed of a dielectric layer having low dielectric loss.

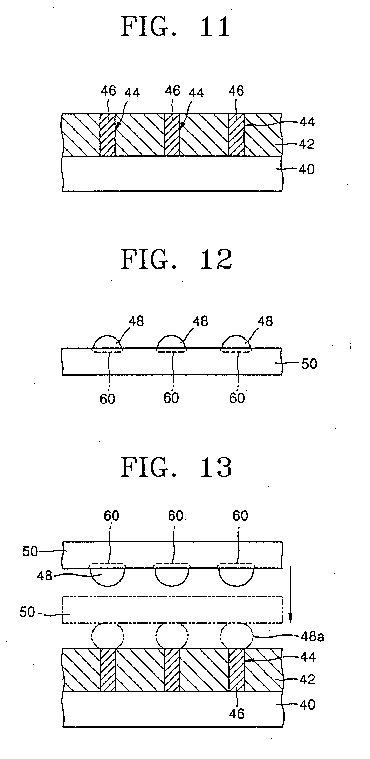

Next, as can be seen in FIG. 10, contact holes 44, which expose the substrate 40, are formed in the interlayer dielectric layer 42. As shown in FIG. 11, the contact holes 44 are filled with conductive plugs 46. Here, the surface of the resultant structure is planarized. The conductive plugs 46 are used as first inductor means.

As shown in FIG. 12, bump members 48 for flip-chip bonding are formed on pad areas 60 of an RF chip 50 including a transmitter and a receiver respectively composed of active and passive devices. As shown in FIG. 13, the RF chip 50 turns upside down, and then is arranged so that the bump members 48, on a one-to-one basis, correspond to the conductive plugs 46. Thereafter, the RF chip 50 is flip-chip bonded to the substrate 40. As a result, first inductors according to the present embodiment are completed. In this process, the bump members 48 are melted at a predetermined temperature and pressure so as to form flip-chip bumps 48a between the pad areas 60 of the RF chip 50 and the conductive plugs 46. The flip-chip bumps 48a are used as second inductor means. Accordingly, inductors having a low inductance necessary for input and output ports (not shown) of the RF chip 50.

As described above, since the bump members 48 correspond on a one-to-one basis to the conductive plugs 46, it is preferable that a distance between the contact holes 44 and a diameter of the contact holes 44 are set in consideration of a distance between the pad areas 60 of the RF chip 50 and the size of the bump members 48.

Alternatively, the bump members 48 may be formed on the interlayer dielectric layer 42 so as to contact the conductive plugs 46, the RF chip 50 may be arranged so that the pad areas 60 of the RF chip 50 correspond on a one-to-one basis to the bump members 48, and the RF chip 50 and the substrate 40 may be pressed at a predetermined temperature and with a predetermined pressure so that the RF chip 50 is bonded to the substrate 40.

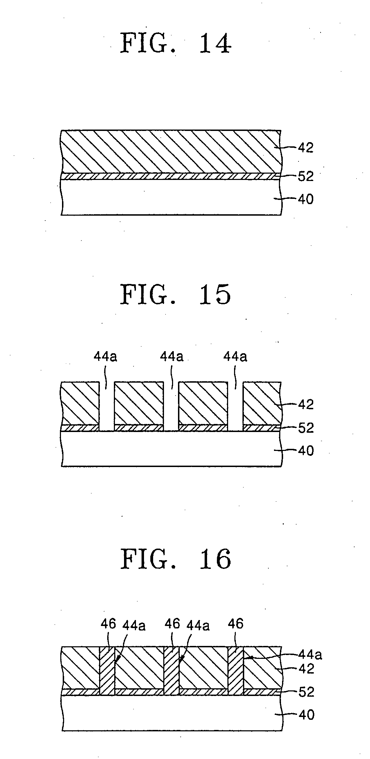

FIGS. 14 through 17 are cross-sectional views for explaining steps of a method of manufacturing inductors used in a RF unit for a wireless communication terminal according to another embodiment of the present invention.

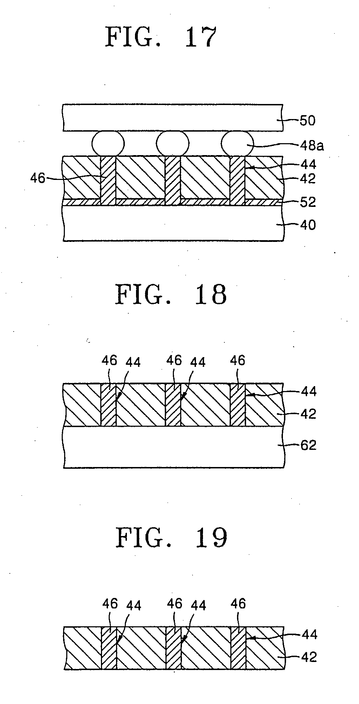

Referring to FIG. 14, a conductive adhesive film 52 and an interlayer dielectric layer 42 are sequentially formed on a substrate 40. The conductive adhesive film 52 serves to strongly adhere the interlayer dielectric layer 42 onto the substrate 40 and may be electrically connected to wire (not shown) of the substrate 40. As shown in FIG. 15, contact holes 44a, which expose the substrate 40, are formed in the conductive adhesive film 52 and the interlayer dielectric layer 42. Next, as shown in FIG. 16, the contact holes 44a are filled with conductive plugs 46, and then the resultant structure is planarized. Thereafter, steps that are to be described with reference to FIG. 17 are the same as those described in the previous embodiment, and inductors as shown in FIG. 5 are completed.

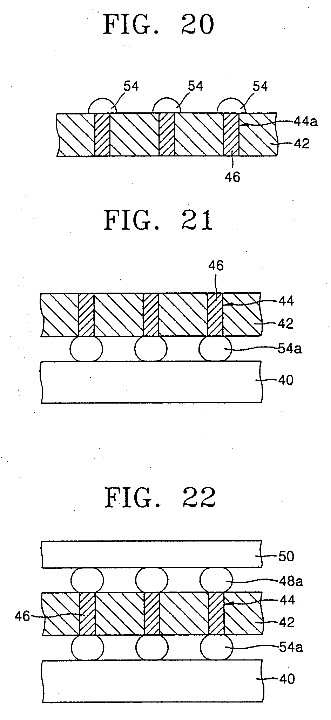

FIGS. 18 through 22 are cross-sectional views for explaining steps of a method of manufacturing the inductors used in an RF unit for a wireless communication terminal according to still another embodiment of the present invention. An interlayer dielectric layer 42 is formed on a substrate 62. Contact holes 44, which expose the substrate 62, are formed in the interlayer dielectric layer 42. The contact holes 44 are filled with conductive plugs 46, and then the resultant structure is planarized. Thereafter, as shown in FIG. 19, the interlayer dielectric layer 42 including the contact holes 44 filled with the conductive plugs 46 is separated from the substrate 62. As shown in FIG. 20, bump members 54, which contact the conductive plugs 46 and, preferably, cover the entire exposed surfaces of the conductive plugs 46, are formed on a side of the separated interlayer dielectric layer 42. Next, as shown in FIG. 21, the side of the interlayer dielectric layer 42 on which the bump members 54 are formed turns upside down so that it faces the substrate 40, and then the interlayer dielectric 42 is bonded to the substrate 40 using the bump members 54. In this process, the bump members 54 are supplied with a predetermined temperature and pressure, and thus first flip-chip bumps 54a are formed so as to connect the interlayer dielectric layer 42 to the substrate 40. A step of flip-chip bonding an RF chip 50 to the interlayer dielectric 42 that is flip-chip bonded to the substrate 40 is the same as that described with reference to FIGS. 9 through 13, and inductors as shown in FIG. 6 are completed. The completed inductors are composed of flip-chip bumps 48a and 54a and the conductive plugs 46.

The embodiments described with reference to FIGS. 7 and 8 are characterized by including step of forming the conductive adhesive film 56 between the interlayer dielectric 42 including the conductive plugs 46 and the flip-chip bumps 48a according to the embodiment described with reference to FIGS. 9 through 13, and step of forming the conductive adhesive film 58 between the substrate 40 and the flip-chip bumps 54a according to the embodiment described with reference to FIGS. 18 through 22.

The embodiment described with reference to FIG. 8 may further include steps of forming a conductive adhesive film on the entire surface of the interlayer dielectric layer 42 and the entire exposed surfaces of the conductive plugs 46, and adhering the RF chip 50 onto the conductive adhesive film via the flip-chip bumps 48a.

In the method described with reference to FIGS. 14 through 17, after a conductive adhesive film may be formed on the entire surface of the interlayer dielectric film 42 and the entire exposed surfaces of the conductive plugs 46, and then the RF chip 50 may be bonded to the conductive adhesive film via the flip-chip bumps 48a.

As described above, since conductive plugs belonging to components constituting inductors are enclosed by a dielectric layer having low dielectric constant, conductivity, and loss tangent, substrate loss can be minimized, which results in a high Q-factor of the inductors. Also, since the capacitance of parasitic capacitors is very small, a high SRF can be obtained. In addition, since short conductive plugs as well as flip-chip bumps can be highly re-formed using a semiconductor manufacturing process, inductors having a low inductance and a low inductance variation can be manufactured. Furthermore, since flip-chip bonding is used, the size of a chip can be reduced to 30 % or less of the size of a chip using wire bonding.

The present invention has been particularly shown and described with reference to exemplary embodiments thereof. However, the embodiments of the present invention can be modified into various other forms, and the scope of the present invention must not be interpreted as being restricted to the embodiments. For example, it will be understood by those of ordinary skill in the art that a new process of forming flip-chip bumps can be developed and applied to a method of manufacturing inductors according to the embodiments of the present invention, the interlayer dielectric layer 42 can be a plurality of interlayer dielectric layers having as low dielectric constant as possible, and the contact holes 44 can be modified into various other forms. For example, instead of contact holes having a uniform diameter as described according to the embodiments of the present invention, stepped contact holes having partially or sequentially different diameters can be formed and filled with conductive plugs that are inductor elements. Therefore, the scope of the present invention must be defined by the appended claims not by the above-described embodiments.

## Claims

1. Inductors used in a RF unit for a wireless communication terminal, the inductors comprising:
first inductor means (46) that electrically connect an RF chip (50) placed over a substrate (40) at a predetermined distance to the substrate (40) and are enclosed by a low loss dielectric material (42); and
second inductor means (48a) that connect the RF chip (50) to the first inductor means (46).

2. The inductors of claim 1, wherein the first inductor means (46) are conductive plugs (46), lower portions of which are connected to the substrate (40) and upper portions of which are connected to the second inductor means (48a).

3. The inductors of claim 2, wherein the second inductor means (48a) are flip-chip bumps (48a) contacting the upper portions of the conductive plugs (46).

4. The inductors of claim 3, further comprising a conductive adhesive film (52), which encloses the conductive plugs (46), between the low loss dielectric material (42) and the substrate (40).

5. The inductors of claim 3, wherein the conductive plugs (46) are connected to the substrate (40) via third inductor means (54a).

6. The inductors of claim 5, further comprising a conductive adhesive film (58) between the third inductor means (54a) and the substrate (40).

7. The inductors of claim 6, further comprising a conductive adhesive film (56) between the flip-chip bumps (48a) and the conductive plugs (46).

8. The inductors of claim 5 or 6, wherein the third inductor means (54a) are flip-chip bumps (54a).

9. The inductors of claim 3 or 4, further comprising a conductive adhesive film (56) between the flip-chip bumps (48a) and the conductive plugs (46).

10. RF chip apparatus comprising:
a substrate (40);
an RF chip (50); and
inductors according to any preceding claim connecting the RF chip (50) to the substrate (40).

11. A method of manufacturing inductors, the method comprising:
forming an interlayer dielectric layer (42) having a low dielectric constant on a substrate (40);
forming first inductor means (46) that penetrate through the interlayer dielectric layer (42) so as to be connected to the substrate (40); and
forming an RF chip (50) over the interlayer dielectric film (42) at a predetermined distance via the first inductor means (46) and second inductor means (48a) connected to pad areas (60) of the RF chip (50).

12. The method of claim 11, wherein forming the first inductor means (46) comprises:
forming contact holes (44) in the interlayer dielectric layer (42) to expose the substrate (40); and
filling the contact holes (44) with conductive plugs (46) that are the first inductor means (46).

13. The method of claim 12, wherein forming the RF chip (50) comprises:
forming flip-chip bumps (48a) beneath the pad areas (60) of the RF chip (50);
arranging the RF chip (50) so that the flip-chip bumps (48a) correspond on a one-to-one basis to the conductive plugs (46); and
pressing the substrate (40) and the RF chip (50) at a predetermined temperature and with a pressure so as to bond the RF chip (50) to the substrate (40).

14. The method of claim 12, wherein forming the RF chip (50) comprises:
forming bumps (48) contacting the conductive plugs (46) on the interlayer dielectric layer (42);
arranging the RF chip (50) so that the pad areas (60) of the RF chip (50) correspond on a one-to-one basis to the bumps (48); and
pressing the substrate (40) and the RF chip (50) at a predetermined temperature and with a predetermined pressure so as to bond the RF chip (50) to the substrate (40).

15. The method of any of claims 11 to 14, wherein before the interlayer dielectric layer (42) is formed, a conductive adhesive film (52) is formed.

16. The method of claim 13 or 14, wherein before the substrate (40) and the RF chip (50) are pressed, a conductive adhesive film (56) covering the exposed surfaces of the conductive plugs (46) is formed on the interlayer dielectric layer (42).

17. A method of manufacturing inductors, the method comprising:
forming an interlayer dielectric layer (42) having a low dielectric constant and including first inductor means (46) formed in the interlayer dielectric layer (42);
placing the interlayer dielectric layer (42) over a substrate (40) at a predetermined distance via third inductor means (54a) connecting the first inductor means (46) to the substrate (40); and
placing an RF chip (50) over the interlayer dielectric layer (42) at a predetermined distance via second inductor means (48a) connecting the first inductor means (46) to pad areas (60) of the RF chip (50).

18. The method of claim 17, wherein forming the interlayer dielectric layer (42) comprises:
forming the interlayer dielectric layer (42) on a first substrate (62);
forming contact holes (44) in the interlayer dielectric layer (42) so as to expose the first substrate (62);
filling the contact holes (44) with the first inductor means (46); and
separating the interlayer dielectric layer (42) from the first substrate (62).

19. The method of claim 17, wherein the second and third inductor means (48a, 54a) are flip-chip bumps.

20. The method of claim 19, wherein placing the interlayer dielectric layer (42) over the substrate (40) comprises:
forming the flip-chip bumps (54, 54a) on the substrate (40) in consideration of a distance between the pad areas (60) of the RF chip (50) and the area of the pad areas (60);
arranging the interlayer dielectric layer (42) so that first inductor means (46) correspond on a one-to-one basis to the flip-chip bumps (54a); and
pressing the substrate (40) and the interlayer dielectric layer (42) at a predetermined temperature and with a predetermined pressure to flip-chip bond the interlayer dielectric layer (42) to the substrate (40).

21. The method of claim 19, wherein placing the interlayer dielectric layer (42) over the substrate (40) comprises:
forming flip-chip bumps contacting the first inductor means (46) on a side of the interlayer dielectric layer (42); and
pressing the substrate (40) and the interlayer dielectric layer (42) at a predetermined temperature and with a predetermined pressure to bond the interlayer dielectric layer (42) to the substrate (40).

22. The method of claim 20 or 21, wherein placing the RF chip (50) over the interlayer dielectric layer (42) comprises:
forming the flip-chip bumps (54, 54a) beneath the pad areas (60) of the RF chip (50);
arranging the RF chip (50) so that the flip-chip bumps (54, 54a) correspond on a one-to-one basis to the first inductor means (46); and
pressing the substrate (40) and the interlayer dielectric layer (42) at a predetermined temperature and with a predetermined pressure to bond the interlayer dielectric layer (42) to the substrate (40).

23. The method of claim 22, wherein before the interlayer dielectric layer (42) is flip-chip bonded to the substrate (40), a conductive adhesive film (52, 58) is formed on the substrate (40).

24. The method of claim 22 or 23, wherein before the interlayer dielectric layer (42) is flip-chip bonded to the RF chip (50), a conductive adhesive film (56) covering the exposed surfaces of the first inductor means (46) is formed on the interlayer dielectric layer (42).

25. The method of any of claims 17 to 24, wherein the first inductor means (46) are conductive plugs (46).
